# EUROPEAN PATENT APPLICATION

(11) **EP 2 680 298 A1**
(43) Date of publication of application: **01.01.2014**
(21) Application number: 12850303.4
(22) Date of filing: 12.11.2012
(51) Int. Cl.: H01L 21/3065, B81C 1/00

(54) **METHOD AND DEVICE FOR DETECTING TERMINATION OF ETCHING**

(30) Priority: 14.11.2011 JP 2011248861
(71) Applicant: Fuji Electric Co., Ltd., Kawasaki-shi Kanagawa 210-9530 (JP)
(72) Inventor: TOMIZAWA, Hiroshi, Kawasaki-shi Kanagawa 210-9530 (JP); FURUICHI, Takuya, Kawasaki-shi Kanagawa 210-9530 (JP)
(74) Representative: MERH-IP Matias Erny Reichl Hoffmann
(86) International application number: PCT/JP2012/007255
(87) International publication number: WO 2013/073160

(57) **Abstract**

Provide is an etching completion detection method that accurately detects an etching completion position in an SOI substrate, regardless of the width of an opening. This etching completion detection method is a method for detecting etching completion when, in an SOI substrate in which a silicon layer is disposed on an insulating layer, etching the silicon layer to form an annular opening that reaches the insulating layer, the method including: forming a first electrode layer on a surface of an islet region that is surrounded by the opening formed by the etching, and a second electrode layer in a region outside the stripe region; measuring an electrical resistance between the first electrode layer and the second electrode layer; and determining that the annular opening reaches an etching completion position when the electrical resistance exceeds a preset threshold.

## Description

### TECHNICAL FIELD

The present invention relates to a method and apparatus for detecting etching completion when, in an SOI substrate in which a silicon layer is disposed on an insulating layer, etching the silicon layer to form an annular opening that reaches the insulating layer.

### BACKGROUND ART

In a capacitive acceleration sensor that has a movable electrode and a fixed electrode for detecting an acceleration as a change in capacitance, the movable electrode and the fixed electrode are formed on an SOI substrate.
In order to produce the capacitive acceleration sensor, a plurality of grooves are patterned on a surface of the SOI substrate into shapes corresponding to the movable electrode and the fixed electrode by using, for example, a resist, and thereafter a silicon layer of the SOI substrate is subjected to dry etching. In an etching processing method used in this case, a processing time until an insulating layer below the silicon layer is exposed is calculated beforehand, and the depth of the grooves are measured by using a laser microscope or the like to monitor whether the silicon layer is etched down to the insulating layer. There is another method in which a unique plasma emission spectrum that is generated by a product of reaction between etching gas and silicon is monitored, and when the intensity of the plasma emission spectrum falls to a predetermined value or less as a result of completely etching off the silicon layer, it is determined that the etching is ended.

However, when the structure of the section to be processed is extremely fine, it is difficult to measure the depth of the grooves using a laser microscope or the like, and the light intensity of the unique wavelength generated by the plasma is lowered, making it difficult to accurately detect whether the etching is ended or not.
As the prior art, there is proposed an etching completion detection method, in which, when performing etching on a layer to be etched via a mask under the condition same as or equivalent to that of the etching on a work, a portion of the layer to be etched corresponding to an opening part is removed down to an etching stopping material. Since side etching is generated along the etching stopping material, a portion of the layer to be etched corresponding to a portion for detection is detached from the etching stopping material, and etching completion is detected thereby (see Patent Document 1, for example).

There is also disclosed a method of manufacturing a semiconductor device, in which an impurity layer in the same depth as a desired groove depth is formed under the surface of a semiconductor substrate made of silicon, a mask is formed on this semiconductor substrate, a groove is formed by ion plasma etching, then electrical resistance between both sides across the groove in the semiconductor substrate is measured using a measuring probe, and the etching is stopped as soon as the resistance rises rapidly (see Patent Document 2, for example).

There is also proposed an etching end-point control pattern in which a semiconductor thin film composed of low-resistance n⁺ amorphous silicon is formed on a semiconductor layer on a surface of an insulating layer, the semiconductor layer being composed of, for example, high-resistance polysilicon, and a conductive resist pattern is formed on this semiconductor thin film to etch only the low-resistance thin film. When leaving a pattern in the shape of an islet, an inspection region is formed in the vicinity of a desired pattern by forming two islet patterns facing each other, in such a manner that a residue of a low-resistance region can be detected by measuring an electrical resistance (see Patent Document 3, for example).

Patent Document 1: Japanese Patent Application Publication No. 2006-150563
Patent Document 2: Japanese Patent Application Publication No. S60-167332
Patent Document 3: Japanese Patent Application Publication No. S62-256438

Incidentally, according to the conventional example described in Patent Document 1, when the SOI substrate is etched, completion of the etching can physically be detected when the portion of the silicon layer reaches down the insulating layer. In other words, detachment of the portion of the layer to be etched, from the etching stopping material, is detected in the side etching generated along the etching stopping material after the etching on the silicon layer is completed. However, the problem of the conventional example described in Patent Document 1 is that the timing for detecting the completion of the etching is delayed, because the detachment of the portion of the layer to be etched corresponding to the portion for detection is detected using the side etching generated along the etching stopping material after the etching progresses to reach the etching stopping material.

In each of the conventional examples described in Patent Documents 2 and 3, on the other hand, the completion of the etching on not the SOI substrate but the semiconductor substrate is detected based on the changes of the resistance. In the conventional example described in Patent Document 2, the measuring probes are applied, through the masks, to the impurity layers on both sides of the groove that is etched thereon. Therefore, how the measuring probes are applied affects the measurement results. Moreover, due to the narrow ranges in which the electrical resistances are detected, it cannot be determined whether the etching is completed or not in a relatively long range.

### DISCLOSURE OF THE INVENTION

The problem of Patent Document 3 is that, because a low-resistance semiconductor thin film is formed on a high-resistance semiconductor layer and then a conductive mask is formed on this semiconductor thin film, a step of removing the mask after completion of the etching is required. This conventional example cannot be applied to a case in which an insulating mask is used as an etching mask used on an SOI substrate.
The present invention was contrived in view of these unsolved problems of the conventional examples, and an object of the present invention is to provide a method and apparatus for detecting etching completion, capable of accurately detecting the time to complete the etching at which a groove formed by etching of a silicon layer of an SOI substrate reaches an insulating layer.

In order to achieve this object, a first aspect of an etching completion detection method according to the present invention is a method for detecting etching completion when, in an SOI substrate in which a conductive silicon layer is disposed on an insulating layer, etching the silicon layer to form an annular opening that reaches the insulating layer. The etching completion detection method includes: configuring an etching completion detector by disposing a first electrode portion on a surface of an islet region that is surrounded by the annular opening formed by the etching, and a second electrode portion in a region outside the islet region; measuring an electrical resistance between the first electrode portion and the second electrode portion; and determining that the annular opening reaches an etching completion position when the electrical resistance exceeds a preset threshold.

According to this first aspect, when forming a groove on the silicon layer of the SOI substrate down to the insulating layer by etching, the first electrode portion and the second electrode portion are disposed on the surface of the islet region and in the region outside the islet region, respectively, the islet region being surrounded by the annular opening formed by the etching. Consequently, the electrical resistance between the electrode portions is measured. At this stage, when the depth of the etched annular opening forming the islet region does not yet reach the insulating region, the islet region and the outer region that face each other with the annular opening therebetween remain connected by the silicon layer. Hence, the electrical resistance between the first and second electrode portions remains low. Thereafter, when the etching progresses to the point where the depth of the etched annular opening becomes as deep as the insulating layer, the first electrode portion and the second electrode portion are connected to each other by the insulating layer. Therefore, the electrical resistance between the first and second electrode portions exceeds the preset threshold. As a result, the fact that the annular opening reaches the etching completion position can be detected.

In a second aspect of the etching completion detection method according to the present invention, the etching for the annular opening is performed while measuring the electrical resistance between the first electrode portion and the second electrode portion, and the annular opening is determined to reach the etching completion position when the electrical resistance exceeds the preset threshold.
According to the second aspect, because the etching for the annular opening is performed while measuring the electrical resistance, the etching can be ended when the annular opening reaches the etching completion position, whereby the annular opening that reaches the insulating layer can be formed accurately.

In a third aspect of the etching completion detection method according to the present invention, the annular opening is in the form of a circular or polygonal annular groove.
According to the third aspect, because the annular opening is in the form of a circular or polygonal annular groove, the islet region and the region outside the islet region are certainly insulated from each other by the annular groove without being electrically connected, when the annular groove reaches down the etching completion position. In this manner, the etching completion position can be detected accurately.

In a fourth aspect of the etching completion detection method according to the present invention, the etching completion detector is formed in a region different from a section to be processed which is etched simultaneously with the annular opening.
According to the fourth aspect, even when a non-annular opening is formed in the section to be processed, the etching completion detector can detect that the opening of the section to be processed reaches the etching completion position.

In a fifth aspect of the etching completion detection method according to the present invention, the etching completion detector is formed on an SOI substrate on which the section to be processed is formed.
According to the fifth aspect, because the etching completion detector is formed on the SOI substrate on which the section to be processed is formed, the etching completion detector can accurately detect that the opening of the section to be processed reaches the etching completion position.

In a sixth aspect of the etching completion position detection method according to the present invention, the etching completion detector is formed on an SOI substrate that is different from an SOI substrate on which the section to be processed is formed.
According to the sixth aspect, it is only necessary to form the etching completion detector on a single SOI substrate, when the etching completion detector cannot be formed on an SOI substrate on which a section to be processed is formed, or when a plurality of SOI substrates with sections to be processed need to be etched simultaneously. Thus, the cost of manufacturing SOI substrates can be reduced.

In a seventh aspect of the etching completion detection method according to the present invention, the annular opening is configured to have a width equal to a width of an opening of the section to be processed.
According to the seventh aspect, because the width of the annular opening of the etching completion detector is set to be equal to the width of the opening of the section to be processed, the time to end the etching for the annular opening can accurately be conformed to the time to end the etching for the opening of the section to be processed.

In an eighth aspect of the etching completion detection method according to the present invention, the etching completion detector is configured by a plurality of etching completion detectors respectively having different etching speeds.
According to the eighth aspect, the completion of the etching can be detected in stages by means of the plurality of etching completion detectors. Thus, the completion of the etching can be detected more accurately.

A first aspect of an etching completion detection apparatus according to the present embodiment is an apparatus for detecting etching completion when, in an SOI substrate in which a conductive silicon layer is disposed on an insulating layer, etching the silicon layer to form an opening that reaches the insulating layer. The etching completion detection apparatus includes an etching completion detector that has an annular opening formed by the etching and reaching the insulating layer, an islet region surrounded by the annular opening, a first electrode portion disposed on a surface of the islet region, and a second electrode portion disposed in a region outside the islet region. The etching completion detection apparatus further includes an etching completion determination unit that measures an electrical resistance between the first electrode portion and the second electrode portion by using a resistance measuring device, and determines that the annular opening reaches an etching completion position when the electrical resistance exceeds a preset threshold.

According to the present invention, the first electrode portion is disposed in the islet region that is surrounded by the annular opening etched down to the insulating layer, and the second electrode portion is disposed in the region outside the islet region. The electrical resistance between the electrode portions is measured. When the etching progresses to the point where the depth of the etched annular opening becomes as deep as the insulating layer, the electrical resistance exceeds the preset threshold, whereby the completion of the etching can be detected accurately.

### BRIEF DESCRIPTION OF THE DRAWINGS

Fig. 1 is a plan view showing an SOI substrate applicable to an etching completion detection method according to the present invention;
Fig. 2 shows an etching completion detector of Fig. 1, wherein Fig. 2(a) is a plan view and Fig. 2(b) a cross-sectional diagram taken along line A-A of Fig. 2(a);
Fig. 3 is an explanatory diagram showing a method of forming electrodes in the etching completion detector;
Fig. 4 is an explanatory diagram showing the etching completion detection method;
Fig. 5 is a diagram showing changes in resistance occurring during etching;
Fig. 6 is an explanatory diagram showing another example of the etching completion detection method;
Fig. 7 is an explanatory diagram showing another example of the etching completion detector; and
Fig. 8 is an explanatory diagram showing yet another example of the etching completion detector.

### BEST MODE FOR CARRYING OUT THE INVENTION

An embodiment of the present invention is described hereinafter with reference to the drawings.

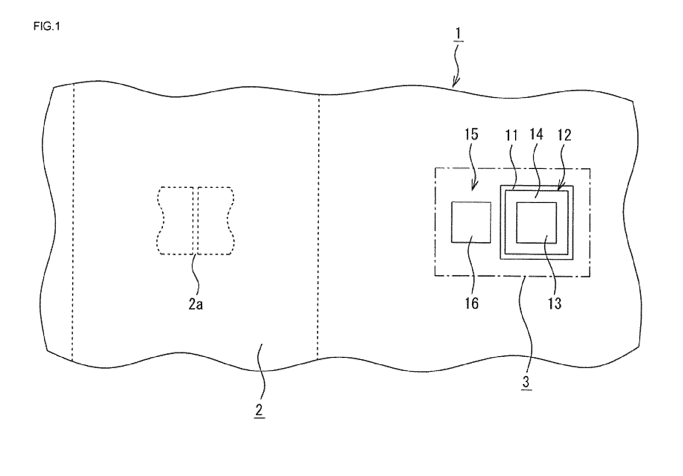

Fig. 1 is a plan view showing an SOI (Silicon-On-Insulator) substrate applicable to an etching method according to the present invention.
As shown in the diagram, reference numeral 1 represents an SOI substrate. A section to be processed 2 for forming various sensors using MEMS (Micro Electro Mechanical Systems) such as a pressure sensor, an acceleration sensor, an angular velocity sensor, and an attitude sensor, and an etching completion detector 3 formed away from the section to be processed 2, are formed in this SOI substrate 1.

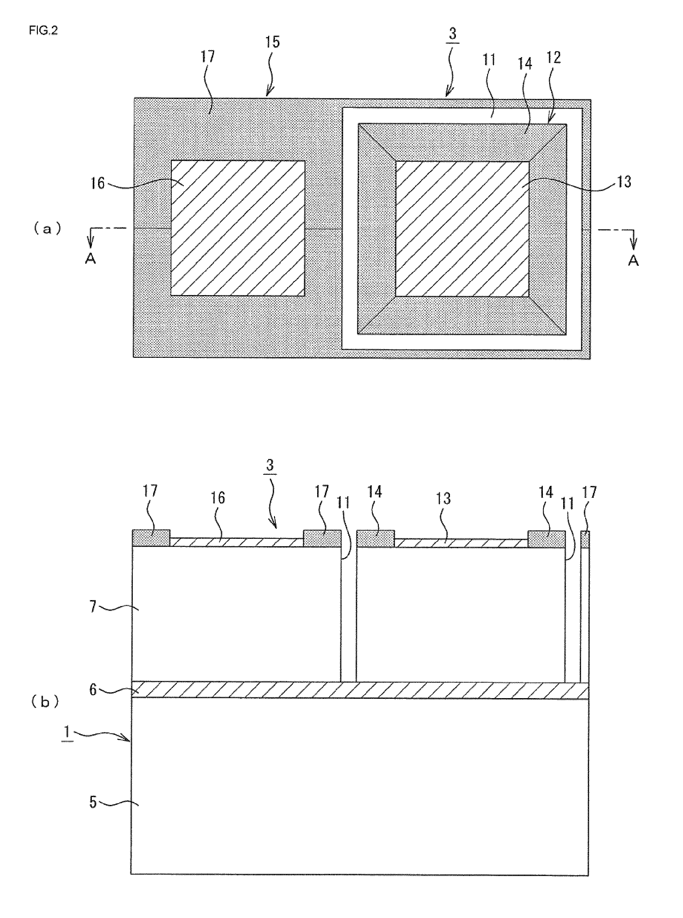

As shown in Fig. 2(b), the SOI substrate 1 is configured by forming an etching stop layer 6, composed of an insulating layer, on a base 5 and forming a layer to be etched 7 on the etching stop layer 6. The base 5 and the layer to be etched 7 are made primarily from silicon exhibiting low-resistance characteristics as represented by a specific resistance ranging from 0.01 to 0.04 [Ω·cm]. The etching stop layer 6 is normally an insulating film composed of an oxide film and has high-resistance characteristics.

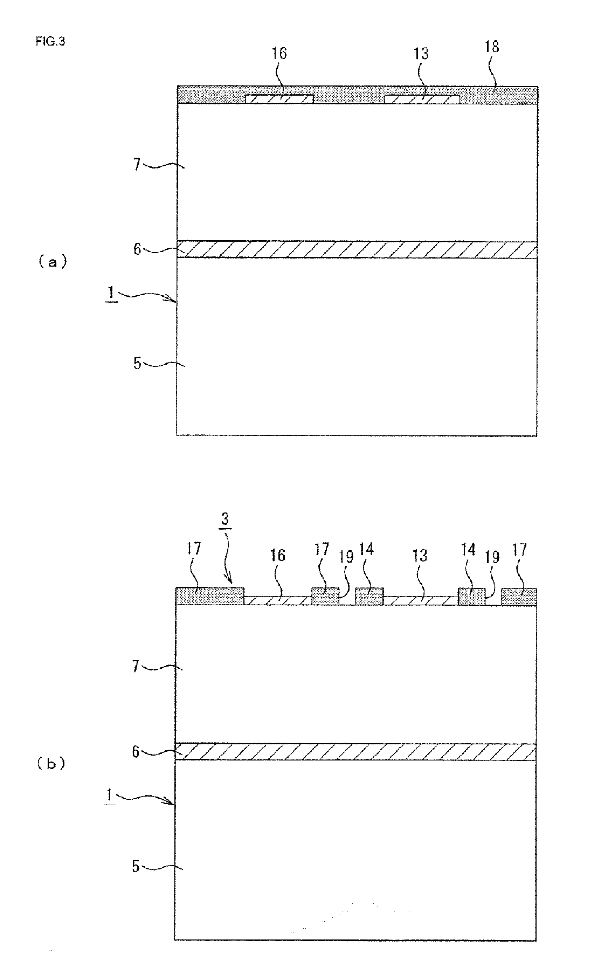

On the section to be processed 2, an opening 2a is formed, by dry etching, into the shape of a groove or space to reach at least the etching stop layer 6 shown in Fig. 3. When dry-etching the section to be processed 2 at this stage, RIE (Reactive Ion Etching) using a CCP (Capacitively Coupled Plasma), ICP (Inductive Coupled Plasma), ECR (Electron Cyclotron Resonance) plasma and the like can be employed.

As shown by the enlarged view in Fig. 2, the etching completion detector 3 has an islet region 12 that is surrounded by an annular opening 11. The annular opening 11 is formed by dry etching so as to reach the etching stop layer 6, and forms an annular groove in the shape of a square frame as viewed planarly. It is preferred that the width of the annular opening 11 be equal to the width of the opening 2a of the section to be processed. The islet region 12 has, at the center of its surface, a first electrode portion 13 that is formed into, for example, a shape similar to the square shape of the annular opening 11. Aluminum or aluminum alloy, for example, which is not subjected to dry etching, is preferably employed as the first electrode portion 13. An insulating mask 14 used for the purpose of etching the annular opening 11 is formed around the first electrode portion 13.

Furthermore, a second electrode portion 16 having the same shape as the first electrode portion 13 is formed on a surface of an outer region 15 outside the islet region 12 across the annular opening 11. As with the first electrode portion, aluminum or aluminum alloy, for example, which is not subjected to dry etching, is preferably employed as the second electrode portion 16. A mask 17 used for the purpose of etching the annular opening 11 is formed around the second electrode portion 16 and outside the annular opening 11.

When forming the etching completion detector 3, first, the first electrode portion 13 and the second electrode portion 16 of aluminum or aluminum alloy are vapor-deposited or sputtered on an upper surface of the surface to be etched 7, and then a mask layer 18 composed of an insulating layer is formed thereon in such a manner as to cover the first electrode portion 13 and the second electrode portion 16, as shown in Fig. 3(a). Subsequently, as shown in Fig. 3(b), the mask layer 18 is etched to expose the first electrode portion 13 and the second electrode portion 16. Then, an annular opening 19 is formed so as to face the annular opening 11, to form the masks 14 and 17.

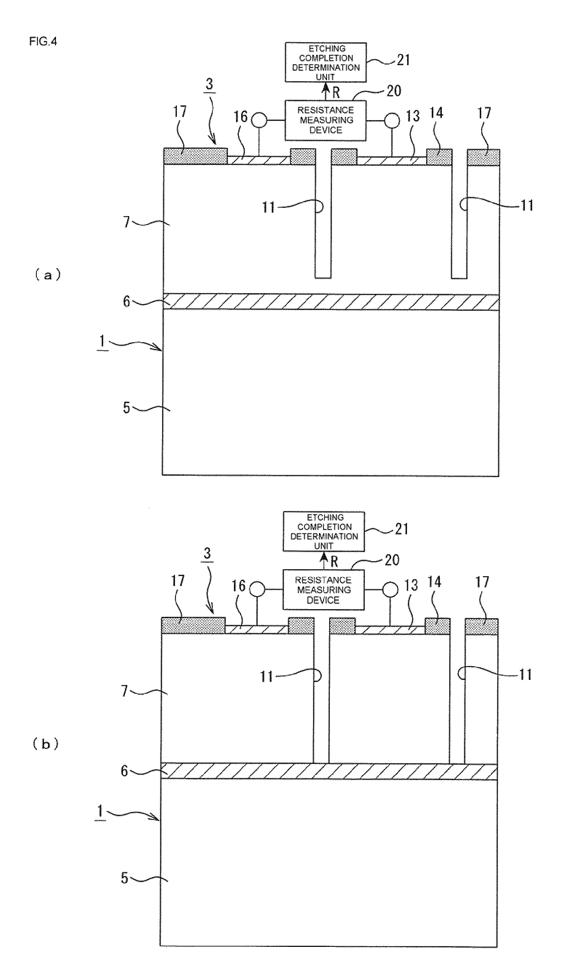

As in the etching completion detector 3, the mask 17 also forms an opening at a section that faces the opening 2a of the section to be processed 2.
When dry-etching the SOI substrate 1 configured as described above, first, as shown in Fig. 4(a), a resistance measuring device 20 such as a multitester is connected between the first electrode portion 13 and the second electrode portion 16, and an etching completion determination unit 21 is connected to a resistance measurement value output side of the resistance measuring device 20.

Subsequently, only the SOI substrate 1 is installed in a dry etching apparatus. At this stage, in a case where dry etching is not yet started, an electrical resistance R to be measured by the resistance measuring device 20 is less than 1 kΩ (R < 1 kΩ) when the specific resistance p of the layer to be etched 7 is 0.01 to 0.04 [Ω·cm].
When dry etching is started in such a state, etching progresses on the annular opening 11 between the masks 14 and 17, as well as on the opening 2a of the section to be processed 2.

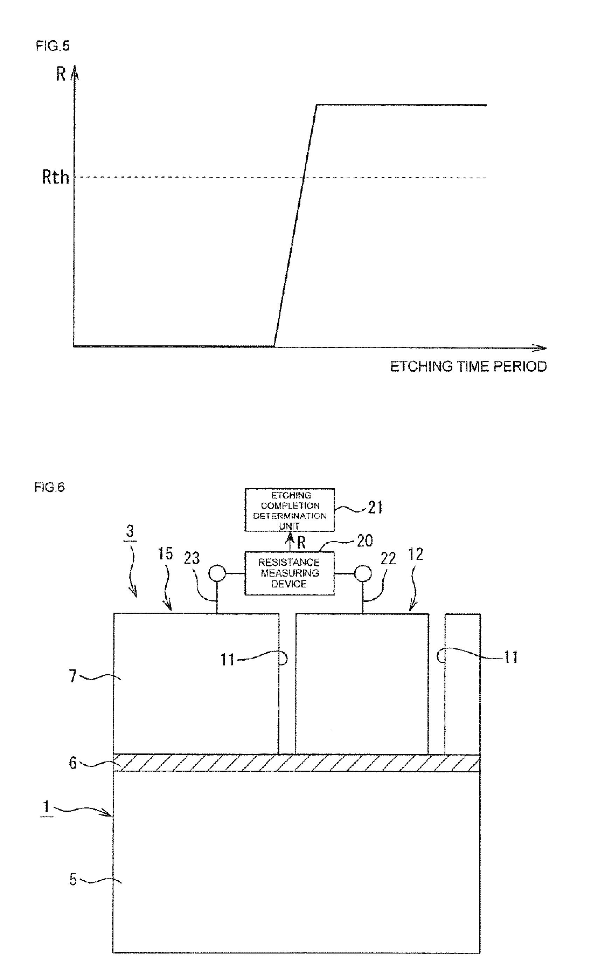

Even when the annular opening 11 is etched almost as deep as the etching stop layer 6 as shown in Fig. 4(a), the electrical resistance R to be measured by the resistance measuring device 20 remains less than 1 kΩ, due to the presence of the relatively thick layer to be etched 7 between the annular opening 11 and the etching stop layer 6.
However, when the annular opening 11 reaches the etching stop layer 6 as shown in Fig. 4(b), the electrical resistance R to be measured by the resistance measuring device 20 rises rapidly, as shown in Fig. 5. Consequently, when the specific resistance p of the layer to be etched 7 is 0.01 to 0.04 [Ω·cm] as described above, the electrical resistance R to be measured rises rapidly to 1 GΩ or higher (R > 1 GΩ), due to the high resistance value of the etching stop layer 6.

At this moment, when the measured electrical resistance R exceeds a preset threshold Rth, the etching completion determination unit 21 determines that the depth of the etched annular opening 11 reaches the etching stop layer 6 at an etching completion position, and then ends the dry etching performed by the dry etching apparatus.
In this case, in order to assure that the annular opening 11 reaches the etching stop layer 6, the etching is ended with a delay of a relatively short, predetermined delay time after the measured electrical resistance R exceeds the threshold Rth. In this manner, the etching can be ended when the annular opening 11 certainly reaches the etching stop layer 6.

By matching the width of the annular opening 11 of the etching completion detector 3 and the width of the opening 2a of the section to be processed 2 to be actually etched, the depth of the etched opening 2a of the section to be processed 2 becomes as deep as the etching stop layer 6 as soon as the etching completion detector 3 detects the completion of the etching. Therefore, the completion of the etching can accurately be managed.
According to the present embodiment, when the electrical resistance R between the first electrode portion 13 and the second electrode portion 16 that is measured by the resistance measuring device 20 reaches the threshold Rth after drying etching is started, the dry etching is stopped. Thus, the fact that the annular opening 11 reaches the etching stop layer 6 can accurately be detected.

Because the first electrode portion 13 and the second electrode portion 16 with the annular opening 11 therebetween are formed into squares, the electrical resistance R rapidly rises when substantially the entire annular opening 11 facing the electrode portions 13 and 16 reaches the etching stop layer 6. Because it is determined that the etching is ended when the annular opening 11 facing the first electrode portion 13 and the second electrode portion 16 reaches the etching stop layer 6 over substantially the entire length of the annular opening 11, the completion of the etching can accurately be detected even when the speed of etching in a circumferential direction of the annular opening 11 varies.

The etching completion detector 3 is independent of the section to be processed 2, and the first electrode portion 13 and the second electrode portion 16 are formed especially for the etching completion detector 3. Therefore, it is not necessary to remove the first electrode portion 13 and the second electrode portion 16 after completion of the etching, thus eliminating an electrode removal step.
The embodiment has described a case in which the moment when the electrical resistance R measured by the resistance measuring device 20 exceeds the threshold Rth is detected as the etching completion time at which the annular opening 11 reaches the etching stop layer 6. However, the present invention is not limited to this embodiment. In other words, because the state in which the annular opening 11 certainly reaches the etching stop layer 6 is also the state in which the electrical resistance R reaches saturation as shown in Fig. 5, this saturation may be detected to end the etching.

Moreover, the etching may be ended in case of executing etching for a previously measured etching time period instead of executing dry etching while measuring the electrical resistance R between the first electrode portion 13 and the second electrode portion 16 by means of the resistance measuring device 20 as described above. In this case, it is preferred that the time required for this dry etching be set based on a time period between the etching start time and the etching completion time, which is measured for the abovementioned dry etching that is executed while measuring the electrical resistance R.

In this case, it is not necessary to measure the electrical resistance R while performing the dry etching. Thus, the first electrode portion 13 does not need to be formed in the islet region 12, nor does the second electrode portion 16 need to be in the region 15 that faces the islet region 12 with the annular opening 11 therebetween, as shown in Fig. 6. Therefore, the entire surface can be covered by the masks.
In addition, whether the annular opening 11 of the SOI substrate 1 that is etched for the set etching time period reaches the etching stop layer 6 or not is confirmed by measuring the electrical resistance R between the islet region 12 and the outer region 15 by using the resistance measuring device 20.

In other words, in a state shown in Fig. 6 in which the masks are removed to expose the surfaces of the islet region 12 and the outer region 15, the electrical resistance R is measured using the resistance measuring device 20 by bringing probes 22 and 23 into contact with, respectively, the surfaces of the electrode portions of the islet region 12 and the region 15 with the annular opening 11 therebetween, each of the probes 22 and 23 being composed of a measuring pointer or an electrode piece narrower than a measuring pointer. In so doing, when the measured electrical resistance R is equal to or greater than the threshold Rth or reaches a saturation resistance value, it can be determined that the annular opening 11 and the opening 2a of the section to be processed 2 certainly reach the etching stop layer 6 at the etching completion position.

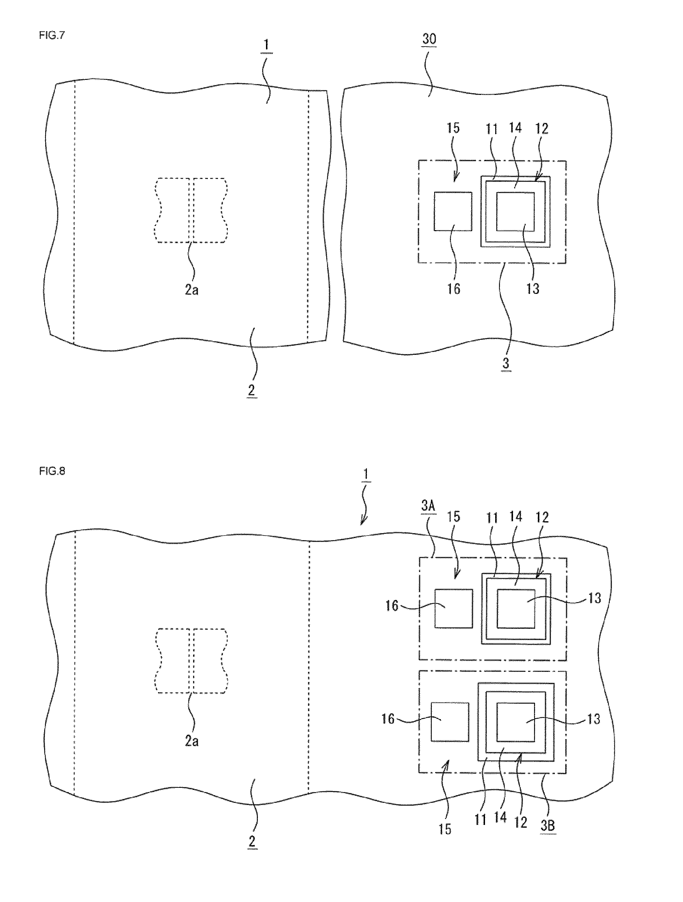

The embodiment has also described a case in which the annular opening 11 of the etching completion detector 3 is in the shape of a square frame as viewed planarly; however, the present invention is not limited thereto. The annular opening 11 can be shaped into a triangle, a polygon of five or more sides, or a circle.
The embodiment has also described a case in which the etching completion detector 3 is formed on the SOI substrate 1 having the section to be processed 2 formed thereon; however, the present invention is not limited thereto. As shown in Fig. 7, the etching completion detector 3 can be formed on an SOI substrate 30, which is different from the SOI substrate 1 having the section to be processed 2 formed thereon.

The embodiment has also described a case in which only one etching completion detector 3 is formed. However, the present invention is not limited to the configuration described in the embodiment. As shown in Fig. 8, a plurality of, for example two, etching completion detectors 3A, 3B having the annular openings 11 of different width are prepared. Then, in each of the etching completion detectors 3, the time to end the etching may be detected in stages by measuring the electrical resistance R between the first electrode portion 13 and the second electrode portion 16. In this case, the time to end the etching can be detected in stages because the etching speed drops as the width of the annular opening 11 narrows from the etching completion detector 3 having the wide annular opening 11.

### INDUSTRIAL APPLICABILITY

The present invention can provide a method and apparatus for detecting etching completion, capable of accurately detecting the time to complete the etching at which a groove formed by etching of a silicon layer of an SOI substrate reaches an insulating layer.

### EXPLANATION OF REFERENCE NUMERALS

1... SOI substrate, 2... Section to be processed, 3... Etching completion detector, 5... Base, 6... Etching stop layer, 7... Layer to be etched, 11... Annular opening, 12... Islet region, 13... First electrode portion, 14... Mask, 15... Outer region, 16... Second electrode portion, 20... Resistance measuring device, 21... Etching completion determination unit, 30... SOI substrate

## Claims

1. A method for detecting etching completion when, in an SOI substrate in which a conductive silicon layer is disposed on an insulating layer, etching the silicon layer to form an opening that reaches the insulating layer, the method comprising:
configuring an etching completion detector by disposing a first electrode portion on a surface of an islet region that is surrounded by the annular opening formed by the etching, and a second electrode portion in a region outside the islet region;
measuring an electrical resistance between the first electrode portion and the second electrode portion; and
determining that the annular opening reaches an etching completion position when the electrical resistance exceeds a preset threshold.

2. The etching completion detection method according to claim 1, wherein the etching for the opening is performed while measuring the electrical resistance between the first electrode portion and the second electrode portion, and the annular opening is determined to reach the etching completion position when the electrical resistance exceeds the preset threshold.

3. The etching completion detection method according to claim 1 or 2, wherein the annular opening is in the form of a circular or polygonal annular groove.

4. The etching completion detection method according to any one of claims 1 to 3, wherein the etching completion detector is formed in a region different from a section to be processed which is etched simultaneously with the annular opening.

5. The etching completion detection method according to any one of claims 1 to 4, wherein the etching completion detector is formed on an SOI substrate on which the section to be processed is formed.

6. The etching completion detection method according to any one of claims 1 to 4, wherein the etching completion detector is formed on an SOI substrate that is different from an SOI substrate on which the section to be processed is formed.

7. The etching completion detection method according to any one of claims 1 to 6, wherein the annular opening is configured to have a width equal to a width of an opening of the section to be processed.

8. The etching completion detection method according to any one of claims 1 to 6, wherein the etching completion detector is configured by a plurality of etching completion detectors respectively having different etching speeds.

9. An apparatus for detecting etching completion when, in an SOI substrate in which a conductive silicon layer is disposed on an insulating layer, etching the silicon layer to form an opening that reaches the insulating layer, the apparatus comprising:
an etching completion detector that has an annular opening formed by the etching and reaching the insulating layer, an islet region surrounded by the annular opening, a first electrode portion disposed on a surface of the islet region, and a second electrode portion disposed in a region outside the islet region; and
an etching completion determination unit that measures an electrical resistance between the first electrode portion and the second electrode portion by using a resistance measuring device, and determines that the annular opening reaches an etching completion position when the electrical resistance exceeds a preset threshold.
